# EUROPÄISCHE PATENTSCHRIFT

(11) **EP 0 378 793 B1**
(45) Veröffentlichungstag und Bekanntmachung des Hinweises auf die Patenterteilung: **25.09.1996**
(21) Anmeldenummer: 89122348.9
(22) Anmeldetag: 04.12.1989
(51) Int. Cl.: H01J 37/065, H01J 37/305, H01J 1/16

(54) **Elektronenemissions-Kathode, Verfahren zum Herstellen und Elektronenstrahlerzeuger mit einer solchen Elektronenemissions-Kathode sowie Vakuumbehandlungsanlage**
Electron emission cathode, its manufacturing process, electron beam supply with such a cathode and vacuum-processing apparatus
Cathode émettrice d'électrons, son procédé de fabrication, émetteur de faisceau électronique comportant une telle cathode et appareil de traitement sous vide

(30) Priorität: 18.01.1989 DE 3901337
(43) Veröffentlichungstag der Anmeldung: 25.07.1990
(73) Patentinhaber: BALZERS AKTIENGESELLSCHAFT, FL-9496 Balzers (LI)
(72) Erfinder: Wegmann, Urs, CH-9479 Oberschan (CH); Koller, Albert, CH-7320 Sargans (CH)
(74) Vertreter: Troesch, Jacques J., Dr. sc. nat.

(56) Entgegenhaltungen:
- DE-A- 1 952 081
- FR-A- 978 627
- GB-A- 2 192 751

## Beschreibung

Die vorliegende Erfindung betrifft eine ElektronenemissionsKathode nach dem Oberbegriff von Anspruch 1, einen Elektronenstrahlerzeuger nach Anspruch 8 sowie eine Vakuumbehandlungsanlage nach Anspruch 10.

Sowohl in der Elektronikindustrie für die Herstellung von Mikroschaltkreisen als auch in der Industrie für die Herstellung von Hart- oder optischen Antireflexschichten werden vielfach Elektronenstrahlverdampfer eingesetzt. Um die hohen Anforderungen an die Homogenität der Schichtdickenverteilung und Schichtdickenreproduzierbarkeit zu erreichen, ist an einem solchen Verdampfer ein thermisch stabiles Strahlerzeugungssystem mit einer präzisen Emissionskathode für reproduzierbare Brennfleckabbildungen im Verdampfungstiegel des Verdampfers äusserst wichtig. Dabei ist es bekannt, den von der Kathode emittierten Elektronenstrahl mittels einer Elektronenoptik vor Auftreffen auf den Tiegel um ca. 270° umzulenken. Dabei wird der Auftreffbereich auf dem Tiegel gesteuert oder geregelt, die Energieverteilung über den Strahlquerschnitt gesteuert und dessen Gesamtenergie wiederum gesteuert oder geregelt. Bezüglich der beheizten Kathode sind somit insbesondere wichtig:
- hohe Materialreinheit,
- hohe Standzeiten,
- gute räumliche Emissionsverteilung zur Sicherstellung guter elektronenoptischer Abbildungen bei hoher Reproduzierbarkeit,
- kurze Reaktionszeiten bei Energieänderungen mittels Heizungsverstellung.

Von Elektronenemissions-Kathoden, wie für die genannten Elektronenstrahlerzeuger, sind grundsätzlich zwei Typen bekannt. Beim ersten Typ wird der elektronenemittierende Teil, nachfolgend "Filament" genannt, indirekt beheizt, d.h. der elektronenemittierende Teil ist unmittelbar in der Nähe einer Heizanordnung angeordnet.

Eine solche Anordnung ist beispielsweise aus dem Art. "Large area lanthanum molybdenum electron emitters" von D.M. Goebel et al., aus Rev.Sci.Instrum. 56 (10), October 1985, American Institute of Physics, S. 1888 bis 1893, bekannt.

Der Vorteil derartiger indirekt beheizter Kathodenanordnungen ist, dass die Emissionsfläche gross ist, nachteilig, dass konstruktiv ein grosser Aufwand betrieben werden muss, die Kathodenbeheizung sicherzustellen, wenn man bedenkt, dass, wegen des Abstandes zwischen emittierendem Filament und Beheizungselement, letzteres für relativ hohe Leistungen ausgelegt werden muss. Der Wirkungsgrad der Anordnung ist schlecht, da ein wesentlicher Teil der Heizungsenergie in die Umgebung verloren geht.

Weiter reagieren solche Kathoden nur träge auf Beheizungsänderungen zum Stellen der Strahlenergie, und sie sind für Emittermaterialien mit hohen Betriebstemperaturen, wie für Wolfram, nicht geeignet.

Eine weitere Art der sogenannten indirekten Kathodenbeheizung besteht darin, die Kathode für den Verdampfungsprozess von hinten mittels Elektronen zu beschiessen, wozu eine sekundäre Kathode mit den ihr zugeordneten Bauelementen nötig ist. Bei solchen Kathoden fallen die erwähnten Nachteile durch Wärmestrahlung indirekt beheizter Kathoden im wesentlichen weg, jedoch ist der Konstruktionsaufwand gross. Dieses Vorgehen wird vornehmlich bei grossflächigen Verdampferkathoden eingesetzt.

Die zweite Art von Elektronenemissions-Kathoden wird direkt beheizt, indem die Kathode durch einen Leiterdraht gebildet wird, welcher durch joulsche Wärme bei Stromdurchfluss erwärmt wird und zur Elektronenemission angeregt wird. Eine solche direkt beheizte Kathodenanordnung wie auch die vorgenannte Anordnung mit Elektronenbeschussbeheizung sind beispielsweise bekannt aus "Elektronenstrahltechnologie" von Schiller, Heisig, Panzer, Wissenschaftliche Verlagsgesellschaft mbH Stuttgart, Jahrgang 1977, S. 40 bis 44.

Der Vorteil direkt beheizter Kathoden ist der bessere Wirkungsgrad, indem die Beheizungsenergie wesentlich besser als bei indirekt beheizten Filaments ausgenützt wird und dass hierzu ein wesentlich geringerer konstruktiver Aufwand betrieben werden muss. Nachteilig ist jedoch, dass bei derartigen bekannten, durch einen elektrischen Leiterdraht gebildeten, direkt beheizten Kathoden die vom Draht aufgespannte Gesamtfläche schlecht ausgenützt ist. Konstruktiv kann der Kathodendraht nicht beliebig eng eine für die Emission vorgegebene Fläche abdecken, denn es muss gegenseitiges Berühren von Drahtabschnitten verhindert werden. Die inhärente Elastizität derartiger Drähte und die Problematik im Herstellungsverfahren, Drahtschenkel neben Drahtschenkel möglichst eng zu legen, ergeben, dass in einer betrachteten, durch einen derartigen Draht aufgespannten Fläche ein überwiegender Anteil durch Zwischenräume eingenommen wird und nur ein geringer Anteil durch den Draht und somit emittiert.

Im übrigen emittiert der üblicherweise im Querschnitt kreisrunde Draht radial verteilt bezüglich der Drahtachse, was eine ungünstig diffuse Gesamtemissionsverteilung über der Drahtwickelkathode ergibt, mit ungünstigen Eigenschaften für die Strahlabbildung.

Aus der Zeitschrift "Neutral-Beam Development", LBL, Berkeley, CA 94720, ist es im weiteren bekannt, eine Heizspirale mit LaB₆-Kristallen zu beschichten und die Beschichtung als Elektronenquelle mittels der eingebetteten Spirale zu beheizen.

Es sei weiter verwiesen auf:
- Steady-state discharge test of coaxial LaB₆ cathode von S. Tanaka et al.; Rev.Sci.Instrum. 59(1), January 1988,
- Directly heated lanthanum hexaboride filaments von K.N. Leung et al.; Rev.Sci.Instrum. 55(7), July 1984,
- Directly heated lanthanum hexaboride cathode von K.N. Leung et al.; Rev.Sci.Instrum. 57(7), July 1986.

Dieses Vorgehen ist ausserordentlich aufwendig, insbesondere, wenn man die thermischen Anforderungen an die Beschichtung berücksichtigt. Auch hier liegt eigentlich eine indirekte Beheizung vor, indem das emittierende Schichtmaterial von der nicht emittierenden Heizspirale beheizt wird. Entsprechendes gilt für die aus der DE-OS 29 33 255 bekannte Elektronenemissionskathode, die aus einem keramischen Material besteht, das aus LaB₆ und einem leitenden, der Beheizung dienenden Material zusammengesetzt ist.

Aus der GB-A-2 192 751 ist eine Elektronenemissionskathode eingangs genannter Art bekannt. Stromanschlüsse sind, bezüglich des Leiterspiralzentrums, sich gegenüberliegend angeordnet. Weil diese Anschlüsse auch als mechanische Verankerungsbereiche für die Kathode eingesetzt werden, führt eine thermisch bedingte Ausdehnung der Kathodenspirale zu einer die Emissionscharakteristik ändernden Verwerfung der Kathodenemissionsfläche.

Der vorliegenden Erfindung liegt die Aufgabe zugrunde, die Vorteile indirekt beheizter Elektronenemissionskathoden, nämlich insbesondere deren grosse Emissionsfläche und gute Emissionsverteilung, mit dem Vorteil direkt beheizter Elektronenemissions-Drahtkathoden zu kombinieren, nämlich der geringen thermischen Trägheit, dem einfachen kompakten Aufbau, der möglichen Minimalisierung und die Einsatzmöglichkeit auf hohen Temperaturen zu betreibender Kathodenmaterialien, und dabei stabile Emissionsverhältnisse zu gewährleisten.

Diese Aufgabe wird, ausgehend von einer ElektronenemissionsKathode der eingangs genannten Art, dadurch gelöst, dass die Anschlussstellen auf derselben Seite des Zentrumsbereiches angeordnet sind.

Bevorzugterweise wird gemäss Wortlaut von Anspruch 2 mindestens entlang wesentlichen Bereichen die Schlitzbreite geringer gewählt als die Breite der durch die Schlitze festgelegten Partien des elektrischen Leiters.

Um im weiteren das aufgrund des Heizstromes durch den Leiter der erfindungsgemässen Kathode entstehende Magnetfeld zu wesentlichen Teilen zu kompensieren, das ansonsten die emittierten Elektronen in unerwünschter Weise ablenken würde, wird gemäss Anspruch 3 vorgeschlagen, die Leiter bifilar anzuordnen.

Im weiteren wird gemäss Anspruch 4 vorgeschlagen, bei der erfindungsgemässen Kathode im Zentrum des Flächengebildes eine Oeffnung vorzusehen oder eine vorzugsweise verbreiterte Partie des Schlitzmusters.

Bekanntlich ist der Zentralbereich derartiger Kathoden der Erosion durch Ionenbeschuss besonders ausgesetzt, da üblicherweise dieser Kathodenbereich auf der elektronenoptischen Achse der nachgeschalteten Elektronenoptik liegt. Wird der Zentralbereich durchgehend belassen, so ergibt sich eine unkontrollierte Erosion, und die Lebensdauer der Kathode wird dadurch drastisch verkürzt. Bei grossflächigen, indirekt beheizten Kathoden ist es deshalb bekannt, beispielsweise aus obgenanntem Werk "Elektronenstrahltechnologie", zentral eine Bohrung vorzusehen, um ihre Lebensdauer zu erhöhen, indem dann Ionen durch die vorgesehene Zentrumsöffnung durchtreten können. Damit wird eine sich während der Lebenszeit einer solchen Kathode ändernde Emissionsfläche vermieden.

Im weiteren ergibt sich durch den erfindungsgemässen Aufbau der Kathode ohne weiteres die Möglichkeit, gemäss Wortlaut von Anspruch 5, durch das Schlitzmuster einen Leiter mit örtlich variierendem Querschnitt zu bilden und somit örtlich gezielt die Entwicklung joulscher Wärme zu beeinflussen und damit die Elektronenemission. Da das geschlitzte Flächenelement relativ steif ist, kann es gemäss Anspruch 6 eine gezielt gekrümmte Fläche bilden, was erlaubt, die Abbildungseigenschaften des elektronenoptischen Systems optimal zu wählen.

Die erfindungsgemässe Kathode kann mittels Funken- bzw. Drahterosion oder mittels Laserschneiden hergestellt werden.

Ein erfindungsgemässer Elektronenstrahlerzeuger weist, gemäss Anspruch 8, eine erfindungsgemässe Kathode auf.

Die Erfindung wird anschliessend beispielsweise anhand von Figuren erläutert.

Es zeigen:
- Fig. 1: in Aufsicht ein Ausführungsbeispiel einer erfindungsgemässen Kathode;
- Fig. 2: ein weiteres Ausführungsbeispiel einer erfindungsgemässen Kathode mit Zentrumsöffnung;
- Fig. 3: ausgehend von der Querschnittsdarstellung nach Linie VI-VI durch eine Kathode gemäss Fig. 2, eine durch deren Verformung gebildete, konkave Kathode.

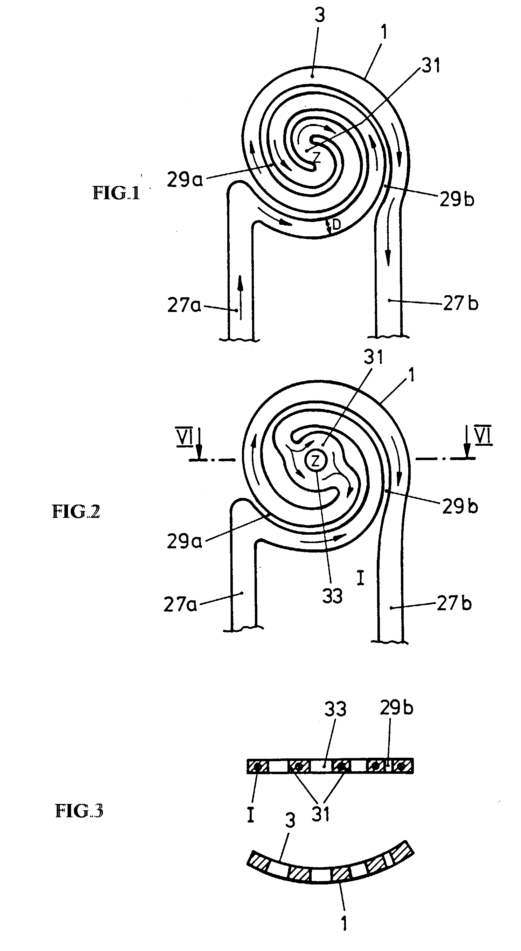

In Fig. 1 ist ein Ausführungsbeispiel einer erfindungsgemässen Kathode, in Aufsicht, dargestellt. Der Körper 1, als Flächengebilde ausgebildet, definiert eine im wesentlichen kreisförmige Emissionsfläche 3. Eine Schlitzanordnung umfasst einen ersten, von einer Stromzuführung 27a sich spiralförmig gegen das Zentrum Z erstreckenden Schlitz 29a, neben welchem ein zweiter, ebenso spiralförmig gegen das Zentrum Z verlaufender Schlitz 29b angeordnet ist. Im Zentrum Z ist die Integrität des Körpers 1 mittels einer verbleibenden Brückenpartie 31 gewährleistet, so dass durch die beiden spiralförmigen Schlitze 29a und 29b eine bifilare Stromleiteranordnung I realisiert ist, durch welche, wie mit den Pfeilen angedeutet, der Heizstrom vom einen Anschluss 27a zum zweiten, auf derselben Seite des Zentrums Z liegenden Anschluss 27b getrieben wird.

Die Breite der Schlitze 29a bzw. 29b ist geringer als die Breite D des Stromleiters I, und es kann gezielt die Wärmeentwicklung und damit die Elektronenemission durch lokale, stetige oder diskontinuierliche Veränderungen des Stromleiterquerschnittes beeinflusst werden. Es ist die Breite D vorzugsweise grösser als die Stärke der das Flächengebilde bildenden Platine.

In Fig. 2 ist ein weiteres Ausführungsbeispiel der erfindungsgemässen Kathode dargestellt, welches sich weitgehend an das Ausführungsbeispiel gemäss Fig. 1 anlehnt. Deshalb sind dieselben Bezugszeichen wie in Fig. 1 gewählt. Im Unterschied zum Ausführungsbeispiel gemäss Fig. 1 ist hier die zentrale, die beiden spiralförmigen Schlitze 29a und 29b überbrückende Partie 31 kreisscheibenförmig ausgebildet, und im Zentrum ist eine bevorzugterweise kreisförmige Durchtrittsöffnung 33, zur Verhinderung der Ionenbeschusserosion unter Selbstfokussierung, vorgesehen. Durch die Oeffnung 33 kann der Ionenstrom durchtreten, ohne die Kathode zu beeinträchtigen. Die optische Achse eines der Kathode nachgeschalteten elektronenoptischen Systems verläuft durch die Oeffnung 33. Bei den Ausführungsbeispielen gemäss den Fig. 1 und 2 werden die spiralförmigen Schlitze bevorzugterweise durch Funken- bzw. Drahterosion oder durch Laserschneiden gefertigt.

Dadurch, dass auch bei der erfindungsgemässen Kathode Schlitze in ein grundsätzlich flächenförmiges Gebilde eingearbeitet werden, ist auch die Elastizität des resultierenden Körpers wesentlich geringer als bei direkt beheizten spiralförmigen Draht-Filaments als Kathoden.

Dies bringt den wesentlichen Vorteil mit sich, dass die erfindungsgemäss ausgebildete Kathode bleibend vorgeformt werden kann, dass, vorzugsweise nach Einarbeiten der Schlitze, der Kathodenkörper 1 insbesondere konvex oder konkav, einer vorgegebenen Raumfläche folgend, ausgebildet werden kann.

In Fig. 3 ist zur Erläuterung des letzterwähnten Vorgehens oben ein Schnitt gemäss Linie VI-VI durch die Kathode gemäss Fig. 2 dargestellt. Nach Herstellung der Kathode in im wesentlichen ebener Konfiguration wird nun, wie unten dargestellt, beispielsweise durch einen Pressvorgang, eine konkave Form gebildet und damit, je nach Anwendungsfall, eine optimale Elektronenemissionsfläche 3 des Kathodenkörpers 1 realisiert.

Als Materialien für die Herstellung der erfindungsgemässen Kathode werden beispielsweise eingesetzt:

Wolfram, Wolfram thoriert 1%, Tantal, Molybdän-Lanthan.

Die erfindungsgemässe Kathode eignet sich vorzüglich als Elektronenquelle für Elektronenstrahlerzeuger in einer oder für eine Verdampferanordnung.

## Patentansprüche

1. Elektronenemissions-Kathode, umfassend ein eine Emissionsfläche definierendes, elektrisch leitendes Flächengebilde (1) sowie eine Heizanordnung zum Beheizen des Flächengebildes (1), wobei die Heizanordnung durch das Flächengebilde (1) gebildet ist, welches hierzu zwei im wesentlichen nebeneinander spiralförmig gegen einen Zentrumsbereich des Flächengebildes verlaufende Schlitze (29) aufweist, welche es, zur Bildung eines elektrischen Leiters zur Erhitzung durch joulsche Wärmeerzeugung, zwischen mindestens zwei vorgegebenen Anschlussstellen (27) unterteilt, dadurch gekennzeichnet, dass die Anschlussstellen auf derselben Seite des Zentrumsbereiches (Z) angeordnet sind.

2. Kathode nach Anspruch 1, dadurch gekennzeichnet, dass die Breite der Schlitze des Schlitzmusters mindestens in wesentlichen Bereichen des Flächengebildes geringer ist als die Breite der durch die Schlitze festgelegten Partien des elektrischen Leiters.

3. Kathode nach einem der Ansprüche 1 oder 2, dadurch gekennzeichnet, dass getrennt nebeneinander liegende Leiterabschnitte von wenigstens wesentlichen Abschnitten des Schlitzmusters, bei Durchlaufen des Leiters von einem Anschluss bis zum anderen, in sich entgegengesetzten Richtungen durchlaufen werden.

4. Kathode nach einem der Ansprüche 1 bis 3, dadurch gekennzeichnet, dass im Zentrumsbereich des Flächengebildes eine vorzugsweise kreisförmige Oeffnung vorgesehen ist oder eine vorzugsweise verbreiterte Partie des Schlitzmusters.

5. Kathode nach einem der Ansprüche 1 bis 4, dadurch gekennzeichnet, dass zur gezielten Beeinflussung der lokalen Elektronenemission durch die Schlitze ein Leiter mit örtlich variierendem Querschnitt gebildet wird.

6. Kathode nach einem der Ansprüche 1 bis 5, dadurch gekennzeichnet, dass das Flächengebilde eine gekrümmte Fläche definiert.

7. Kathode nach einem der Ansprüche 1 bis 6, dadurch gekennzeichnet, dass sie aus Wolfram, Wolframthorint 1%, Tantal oder Molybdän-Lanthan besteht.

8. Elektronenstrahlerzeuger mit einer Elektronenemissions-Kathode nach einem der Ansprüche 1 bis 7.

9. Elektronenstrahlerzeuger nach Anspruch 8, dadurch gekennzeichnet, dass die Achse einer nachgeschalteten Elektronenoptik durch eine Oeffnung des Flächengebildes verläuft.

10. Vakuumbehandlungsanlage mit einem Elektronenstrahlerzeuger nach einem der Ansprüche 8 oder 9.

## Claims

1. Electron emission cathode comprising an electrically conductive surface structure (1) defining an emission surface and a heating arrangement for heating the surface structure (1), where the heating arrangement is formed by the surface structure (1) which for this has two slits (29) running essentially spiral to each other towards a central area of the surface structure which divide it into at least two specified connection terminals (27) to form an electric conductor for heating by Joule heat generation, characterised in that the connection terminals are arranged on the same side of the central area (Z).

2. Cathode according to claim 1, characterised in that the width of the slits in the slit pattern at least in essential areas of the surface structure is less than the width of the parts of the electric conductor defined by the slits.

3. Cathode according to any of claims 1 or 2, characterised in that at least essential sections of the slit pattern pass in opposing directions through conductor sections lying separated next to each other when the conductor runs from one terminal to the other.

4. Cathode according to any of claims 1 to 3, characterised in that in the centre area of the surface structure is provided a preferably circular opening or a preferably enlarged part of the slit pattern.

5. Cathode according to any of claims 1 to 4, characterised in that for targeted influencing of the local electron emissions through the slits, a conductor with locally varying cross-section is formed.

6. Cathode according to any of claims 1 to 5, characterised in that the surface structure defines a curved surface.

7. Cathode according to any of claims 1 to 6, characterised in that it consists of tungsten, tungsten thorium 1%, tantalum or molybdenum lanthanum.

8. Electron beam source with an electron emission cathode according to any of claims 1 to 7.

9. Electron beam source according to claim 8, characterised in that the axis of a subsequent electron lens runs through an opening in the surface structure.

10. Vacuum processing device with an electron beam source according to claim 8 or claim 9.

## Revendications

1. Cathode émettrice d'électrons comprenant une structure plane (1) conductrice d'électricité définissant une surface émettrice, et un dispositif de chauffage destiné à chauffer la structure plane (1), le dispositif de chauffage étant formé par la structure plane (1) qui comporte à cet effet deux fentes (29) globalement juxtaposées et s'étendant en spirale vers une zone centrale de la structure plane, lesquelles fentes (29) divisent cette dernière entre au moins deux points de raccordement prédéfinis (27) afin de former un conducteur électrique destiné à chauffer en générant l'effet Joule, caractérisée en ce que les points de raccordement sont disposés sur le même côté de la zone centrale (Z).

2. Cathode selon la revendication 1, caractérisée en ce que la largeur des fentes du modèle de fentes est inférieure, au moins dans des zones essentielles de la structure plane, à la largeur des parties du conducteur électrique définies par les fentes.

3. Cathode selon la revendication 1 ou 2, caractérisée en ce que des sections de conducteur juxtaposées séparées sont traversées dans des directions opposées au moins par des sections essentielles du modèle de fentes sur l'étendue du conducteur d'un raccordement à l'autre.

4. Cathode selon l'une des revendications 1 à 3, caractérisée en ce qu'il est prévu, dans la zone centrale de la structure plane, une ouverture de préférence circulaire ou une partie de préférence élargie du modèle de fentes.

5. Cathode selon l'une des revendications 1 à 4, caractérisée en ce que pour influer de façon appropriée sur l'émission locale d'électrons à travers les fentes, on forme un conducteur à section transversale localement variable.

6. Cathode selon l'une des revendications 1 à 5, caractérisée en ce que la structure plane définit une surface courbe.

7. Cathode selon l'une des revendications 1 à 6, caractérisée en ce qu'elle se compose de tungstène, de tungstène thorié à 1 %, de tantale ou de molybdène-lanthane.

8. Canon électronique comportant une cathode émettrice d'électrons selon l'une des revendications 1 à 7.

9. Canon électronique selon la revendication 8, caractérisé en ce que l'axe d'un système optique électronique monté en aval traverse une ouverture de la structure plane.

10. Installation de traitement sous vide comportant un canon électronique selon la revendication 8 ou 9.
